# EUROPEAN PATENT SPECIFICATION

(11) **EP 0 640 922 B1**
(45) Date of publication and mention of the grant of the patent: **28.06.2000**
(21) Application number: 94113363.9
(22) Date of filing: 26.08.1994
(51) Int. Cl.: G06F 12/08, G11C 11/408

(54) **Dynamic random access memory (dram) with cache and tag**
Dynamischer Speicher mit wahlfreiem Zugriff mit Cache- und Etikettenspeicher
Mémoire dynamique à accès aléatoire (DRAM) avec antémémoire et dispositif d'étiquette

(30) Priority: 31.08.1993 JP 21602793
(43) Date of publication of application: 01.03.1995
(73) Proprietor: Oki Electric Industry Co., Ltd., Tokyo (JP)
(72) Inventor: Tanoi, Satoru, 1-chome, Minato-ku, Tokyo (JP); Tanaka, Yasuhiro, 1-chome, Minato-ku, Tokyo (JP); Tanabe, Tetsuya, 1-chome, Minato-ku, Tokyo (JP)
(74) Representative: Betten & Resch

(56) References cited:
- EP-A- 0 552 667
- 1990 IEEE INTERNATIONAL CONFERENCE ON COMPUTER DESIGN: VLSI IN COMPUTERS & PROCESSORS 17 September 1990 , MASSACHUSETTS; US pages 417 - 420 NIIJIMA ET AL. 'QRAM - Quick Access Memory System'
- IEEE JOURNAL OF SOLID-STATE CIRCUITS vol. 24, no. 5 , October 1989 , NEW YORK US pages 1176 - 1183 CHOU ET AL. 'A 60-ns 16-Mbit DRAM with a minimized sensing delay caused by bit-line stray capacitance'
- IEEE JOURNAL OF SOLID-STATE CIRCUITS vol. SC-21, no. 5 , October 1986 , NEW YORK US pages 618 - 626 SHAH ET AL. 'A 4-Mbit DRAM with trench-transistor cell'
- IEEE JOURNAL OF SOLID-STATE CIRCUITS vol. 23, no. 5 , October 1988 , NEW YORK US pages 1140 - 1149 LU ET AL. 'A 20-ns 128-kbit x 4 high-speed DRAM with 330-Mbit/s data rate'

## Description

### Reference to Related Application

This application claims the priority of Japanese Patent Application No. Hei 05-216027 filed on August 31, 1993.

### BACKGROUND OF THE INVENTION

### Field of the Invention

The present invention relates to a dynamic random access memory (hereinafter simply referred as DRAM), more particularly, a high speed DRAM with a cache.

### Description of Related Art

A high speed data transmission has been realized by incorporating a cache function into a large scale DRAM. This kind of DRAMs incorporates on a chip a cache memory together with a TAG memory which generates a state flag revealing "Hit" or "Miss" of data stored in the cache memory.

A related technology employing an SRAM as the cache memory is, for example, disclosed in "A circuit design of intelligent CDRAM with automatic write back capability", pp.79-80, 1990 Symposium on VLSI circuits digest of technical papers, June 7-9, The IEEE Solid State-Circuits Council and The Japan Society of Applied Physics, authored by K. Arimoto et al.

In the above technology, a TAG memory stores an X address and a Y address as a pair of TAG addresses, and the SRAM cache stores data corresponding to the TAG address. When the X address and the Y address are defined in a reading operation, confirmation will be made as to whether there exists the TAG address corresponding to the X and Y addresses.

If the TAG address is found in the TAG memory, that is, in case of "Hit", the corresponding data are read out from the SRAM cache with a high speed.

In this manner, a high speed access can be accomplished by incorporating the TAG memory and the SRAM cache into the DRAM circuit. However, the above method requires both the X address and the Y address to map data of column sense amplifiers onto the SRAM cache. Further, a refresh operation is performed in each of sub-arrays constituted of memory cells so that data of the column sense amplifiers renewed in the refresh operation are not always to correspond to the TAG addresses in the TAG memory. Moreover, an external X address or Y address is directly input into the TAG memory simply through a buffer circuit without performing a logic level conversion processing.

As described above, in case that the external address is directly input into the TAG memory through the buffer circuit, the TAG memory in a large scale memory which requires stepped address decoding should be located in front of the first decoding circuit in order to avoid an useless lengthy wiring.

As a result, the TAG memory in a such configurated DRAM is restricted about its layout so that the TAG memory should be located along the X decoder.

Moreover, is employed an address multiplexer type interface where the X address and the Y address are multiplexed and transmitted, the judgement as to "Hit" or "Miss" in the TAG memory cannot be performed until completion of both inputs of the X address and the Y address. Since data are read out through a memory cell (MC) after the judgement as to "Hit" or "Miss" in case of "Miss", a delay of access time on an occasion of "Miss" has been extremely increased.

Moreover, in case that the SRAM cache is utilized as the cache memory, the chip size will be enlarged due to its occupying area, which causes a hike of the cost.

To solve the above problem, there has been proposed a technology utilizing as the cache sense amplifiers of the DRAM circuit. Such a technology is disclosed, for example, in "To realize 500 M bytes/sec data transmission speed by 72 bit row operation" pp. 75-80, August, 1992, Nikkei Microdevices, authored by N. Kushiyama et al. The DRAM, which controls the sense amplifier as the cache, requires that data of the column sense amplifiers should be renewed so that the corresponding addresses in the TAG memory must be purged.

However, the conventional DRAM utilizing the sense amplifiers as the cache has only two TAG blocks constituting the TAG memory on the chip so that different TAG informations cannot be stored in each of the X decoders, which may cause to decrease a hit rate.

Further, the TAG memory assignment in such a DRAM corresponds to plural sub-arrays, each of which incorporates the X decoder, and the TAG memory is concentrated to be located in a different region from that of the memory array. The layout having such the TAG blocks necessitates an useless lengthy bus wiring so that there arises a problem that the TAG blocks cannot be easily increased.

As described above, the conventional DRAM structure incorporating the TAG memory therein encounters difficulties both in reducing the chip size and in improving the hit rate.

### SUMMARY OF THE INVENTION

Accordingly, it is a primary object of the present invention to provide a DRAM with a cache restricting an increase of a chip size.

It is another object of the present invention to provide a DRAM with a cache enabling to reduce a chip size without reducing a hit rate.

It is still another object of the present invention to provide a DRAM with a cache releasing the restriction of a TAG memory arrangement.

To accomplish the above objects, there is provided a dynamic RAM as defined in independent claim 1. The dependent claims define particular embodiments of the invention.

According to an embodiment of the present invention, the plural sub-arrays store data and the X decoder decodes the X address to selectively activate the word lines in the sub-arrays. The column sense amplifiers detect and amplify the read-out data on the bit lines in the sub-arrays. The TAG block in the TAG memory holds the common TAG address for the respective plural sub-arrays concurrently activated, and the sub-array control circuit controls the column sense amplifiers as the cache in accordance with the TAG address.

For example, when "Hit" is recognized in reading operation, data latched on the column sense amplifiers are read out.

Further, according to another aspect of the present invention, the plural sub-arrays store data and the X decoder decodes the X address to selectively activate the word lines in the sub-arrays. The column sense amplifiers detect and amplify data read out from the bit lines in each of the sub-arrays to each of the adjacent sub-arrays. The TAG block in the TAG memory holds the common TAG address for the respective plural sub-arrays concurrently activated and the sub-array control circuit controls the column sense amplifier as the cache. The sense amplifier mediation circuit determines one to be valid and another to be invalid for the portion of the outputs from the adjacent sub-array control circuit.

Moreover, according to the other aspect of the present invention, the first decoder circuit predecodes the address to output the intermediate address. The TAG address holding circuit in the TAG memory loads and holds the intermediate address through the intermediate address bus and supplies the intermediate address to the decoder circuit of the DRAM as well. Further, the address comparison circuit compares the address on the intermediate address bus with that stored in the TAG address holding circuit, and the purge circuit inactivates all the bits of the address stored in the TAG address holding circuit.

The judgement as to "Hit" or "Miss" is performed in accordance with the above described processes. On the other hand, the plural sub-arrays hold data and the decode circuit decodes the address to select the memory cell (MC) in the sub-array.

Further, according to still another aspect of the present invention, the X decoder and the TAG memory are disposed adjacently and in parallel with each other on the chip, and the corresponding TAG blocks are also disposed adjacent to the X decoders prepared for each sub-arrays. As a result, the chip size can be reduced and various wirings can be shortened so that the high speed DRAM can be realized.

### BRIEF DESCRIPTION OF DRAWINGS

Fig. 1 is a block diagram illustrating the first embodiment of a DRAM with a cache according to the present invention;
Fig. 2 is a block diagram illustrating a related technology regarding a DRAM with a cache;
Fig. 3 is a block diagram illustrating a detailed TAG block in the DRAM shown in Fig. 1;
Fig. 4 is a time chart illustrating an operation of the DRAM shown in Fig. 1;
Fig. 5 is a block diagram illustrating a modified example of the first embodiment shown in Fig. 1;
Fig. 6 is a block diagram illustrating the second embodiment of a DRAM with a cache according to the present invention;
Fig. 7 is a block diagram illustrating a decoder portion of the DRAM shown in Fig. 6;
Fig. 8 is a circuit diagram illustrating a circuit example of the first decoder circuit shown in Fig. 7;
Fig. 9 is a logic table illustrating an operation of the case shown in Fig. 8;
Fig. 11 is a block diagram illustrating a modified example of the DRAM shown in Fig. 6;

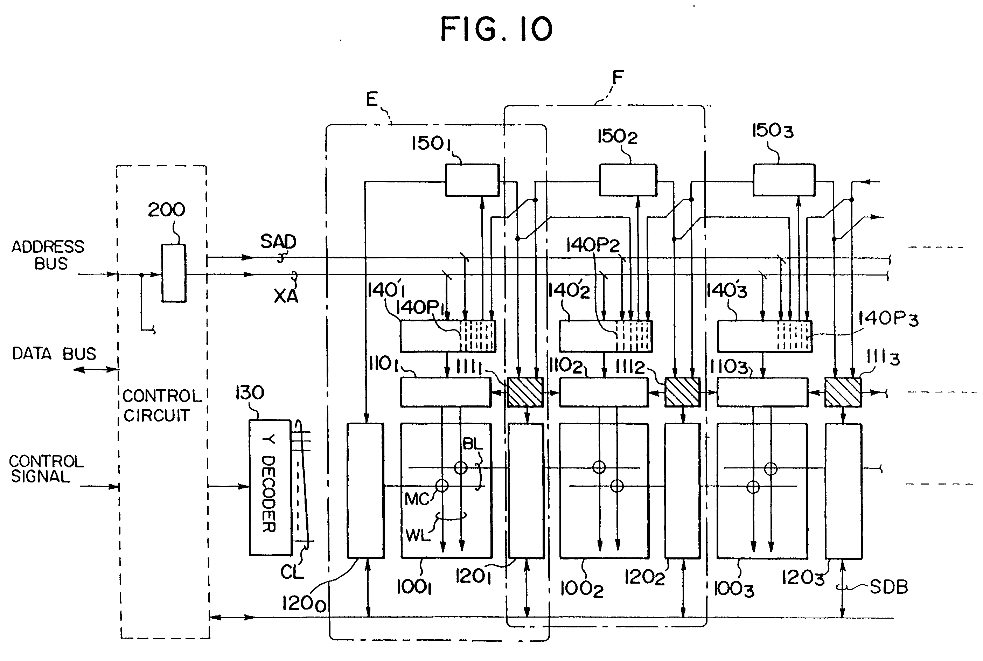

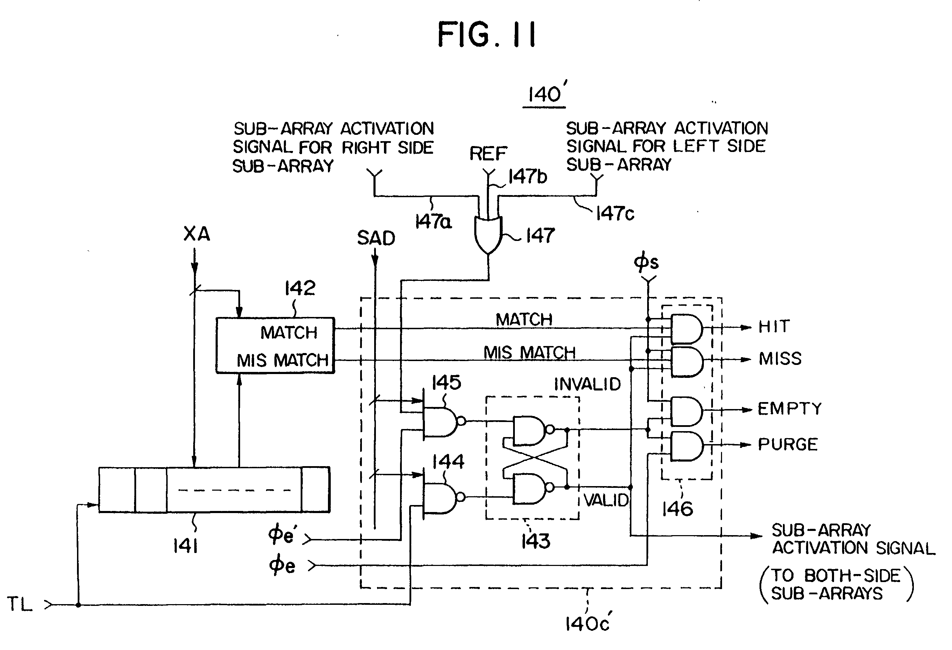

Fig. 11 is a block diagram illustrating a detailed TAG block shown in Fig. 10;

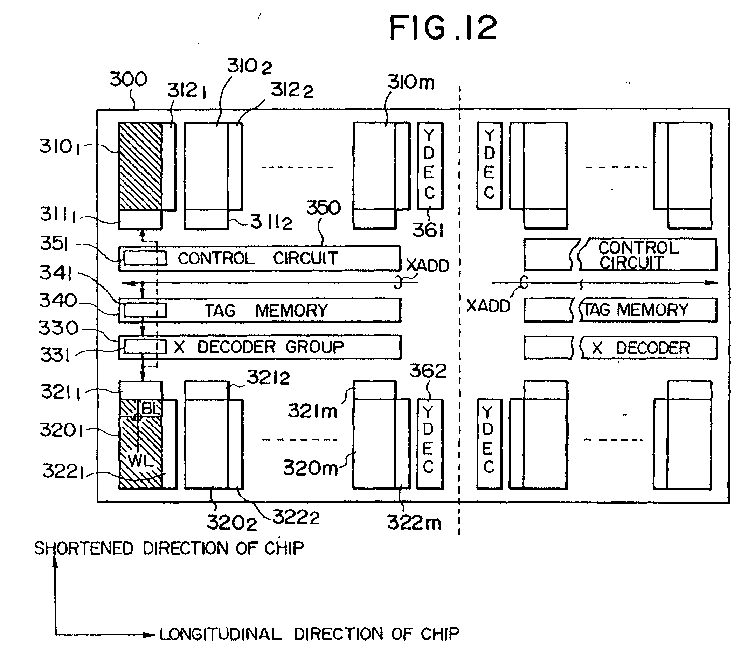

Fig. 12 is a layout illustrating the third embodiment of a DRAM with a cache according to the present invention;

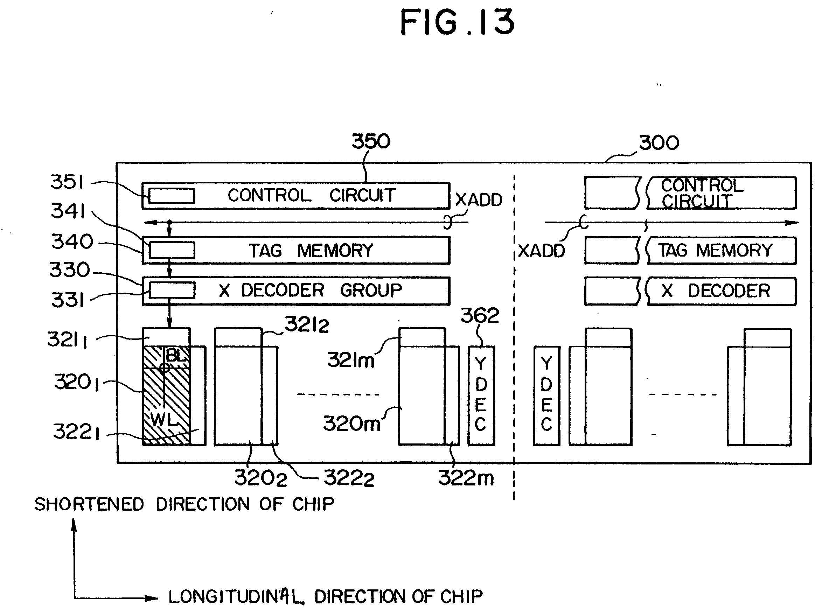

Fig. 13 is another layout illustrating a DRAM with a cache according to the present invention; and

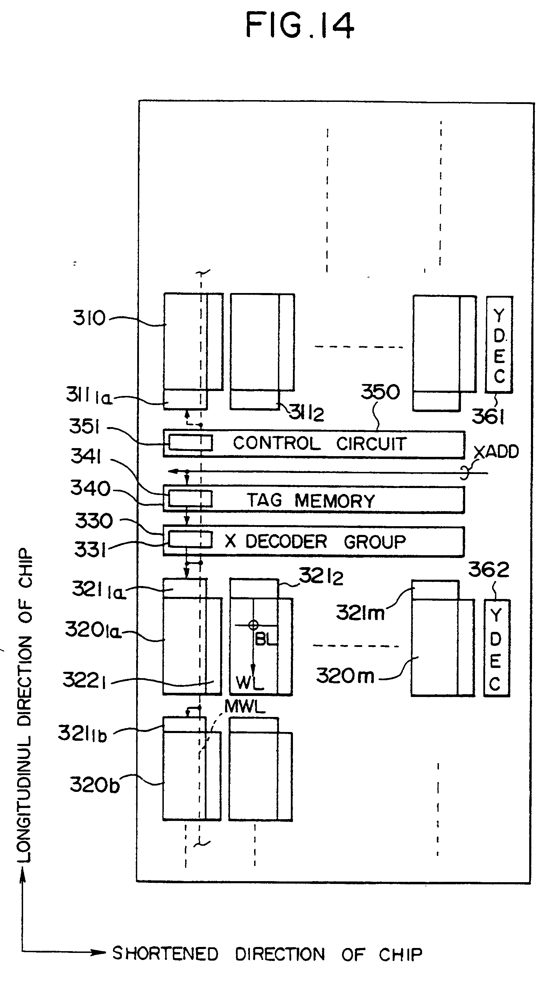

Fig. 14 is still another layout illustrating a DRAM with a cache according to the present invention.

### DETAILED DESCRIPTION OF THE PREFERRED EMBODIMENTS

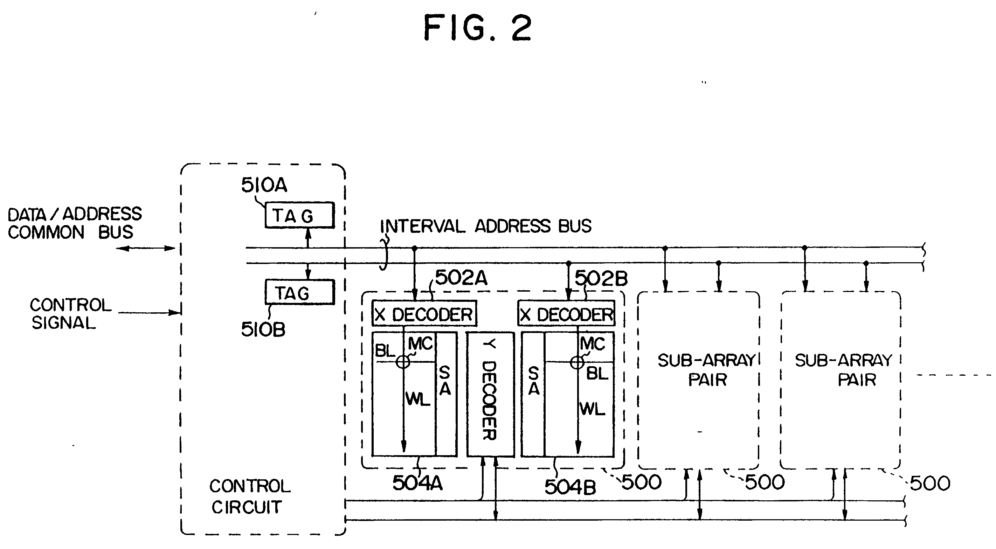

Now, a detailed description will be made as to the embodiments of the DRAM with a cache according to the present invention in reference to the attached drawings. Prior to the description of the embodiments, a related technology will be described first referring to Fig. 2 for the benefit of the better understanding of the present invention.

Fig. 2 is a block diagram illustrating a related technology of the present invention regarding a DRAM utilizing a sense amplifier as a cache.

As shown in Fig. 2, a TAG memory 510 is disposed in a control circuit which feeds input/output signals on a data/address common bus and control signals. A TAG memory 510A and a TAG memory 510B are respectively connected with an X decoder 502 in each of plural sub-array pairs 500. In other words, two TAG memories 510A and 510B on a chip are concentrated to be located in the control circuit region different from that of the sub-array pair 500. The TAG array memory 510A is connected with an X decoder 502A in each sub-array pairs 500 whereas the TAG array memory 510B is connected with an X decoder 502B in each sub-array pairs 500.

The DRAM, which controls the sense amplifier as a cache, must purge the corresponding address in the TAG memory since data of the column sense amplifiers are renewed in a refresh operation.

However, the TAG memory 510 shown in Fig. 2 cannot hold plural different TAG informations in each of decoders. Accordingly, when refreshed a sense amplifier (SA) relating to the X decoder 502 connected with the TAG memory 510, all the TAG addresses stored in the TAG memory 510 are necessitated to be purged. As a result, the DRAM in accordance with the above mentioned related technology reveals a problem that a possibility ratio to hit in the cache, that is, a hit rate remarkably decreases. Next, a DRAM with a cache in accordance with the present invention will be described in details to overcome the above problem.

### First Embodiment

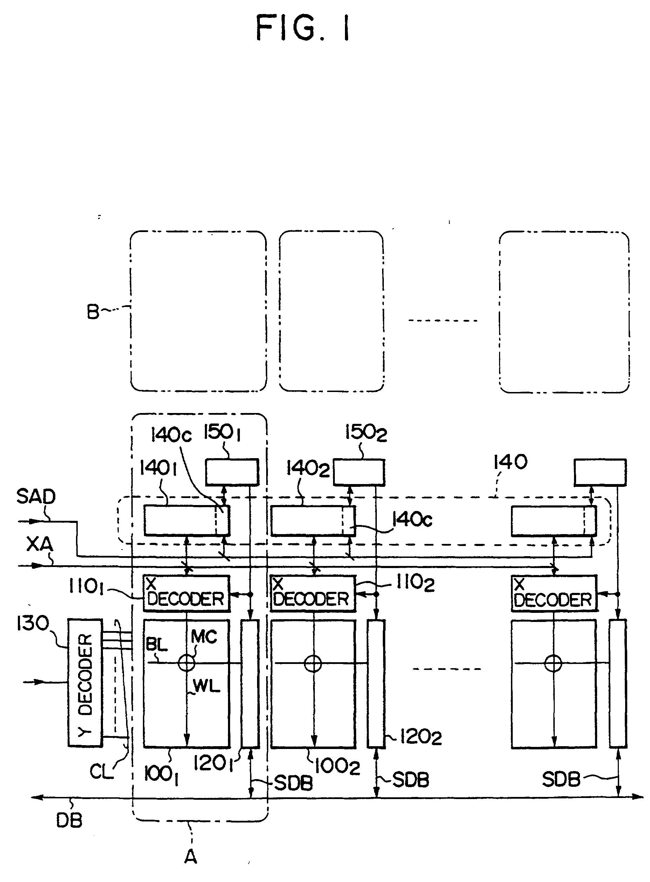

Fig. 1 is a block diagram of a DRAM illustrating the first embodiment of the present invention.

The DRAM shown in Fig. 1 employs a TAG memory constituted of a plurality of TAG blocks to accomplish a high speed access operation. The DRAM is constituted of plural word lines WL, plural bit lines BL, plural sub-arrays 100ⱼ (j = 1, 2, 3, ···) constituted of dynamic type memory cells adequately disposed on the cross points between the word lines WL and the bit lines BL, plural X decoders 110ⱼ which decode the lower bits of the X address from the X address bus XA and selectively activate the word lines in each sub-arrays 100ⱼ, plural column sense amplifiers 120ⱼ respectively connected with the bit lines BL of each sub-arrays 100ⱼ, plural sub-data buses SDB respectively connected with each column sense amplifiers 120 through unillustrated switching circuit, a Y decoder 130 which decodes the Y address to turn on/off the switching circuit and plural TAG memories 140. Since each column sense amplifiers 120ⱼ respectively operate as the cache to the sub-arrays 100ⱼ, they are called, hereinafter, as sense amplifier caches 120ⱼ. Each sense amplifier caches 120ⱼ is connected with a data bus DB through a sub-data bus SDB.

The TAG memory 140, as similar to the plural X decoders 110ⱼ incorporates thereinto plural TAG blocks 140ⱼ which input the lower bits of the X address from the address bus XA and input as the sub-array address the upper bits of the X address from a sub-array address line SAD as well.

Each of the TAG blocks 140ⱼ holds the lower bits of the input X address and outputs a TAG judgement signal in accordance with the X address. Each of the TAG blocks 140ⱼ is arranged in correspondence with the sense amplifier caches 120ⱼ, the sub-arrays 100ⱼ, and the X decoders 110ⱼ, respectively. The sub-array addresses are respectively input to a block control circuit 140c in each TAG blocks 140ⱼ. The DRAM shown in Fig. 1 employs plural sub-array control circuit 150ⱼ respectively outputting control signals to the sense amplifier caches 120ⱼ, the TAG blocks 140ⱼ, and the X decoders 110ⱼ in response to the information from each TAG blocks 140ⱼ. A control unit controlled by each sub-array control circuit 150ⱼ is formed by the control signals from each sub-array control circuit 150ⱼ. For example, the control signal from the sub-array control circuit 150, forms the control unit A shown with one-dot lines in Fig. 1 which corresponds to the TAG block 140₁.

Plural column lines CL driven by the Y decoder 130 are wired on each sub-arrays 100ⱼ and control the switch circuit between the sub-data bus SDB and each sense amplifiers. The sub-data bus SDB is further connected with a data bus DB through the other switching circuit, if necessary. In the present embodiment, each X decoders 110ⱼ has a holding circuit to store the input X addresses.

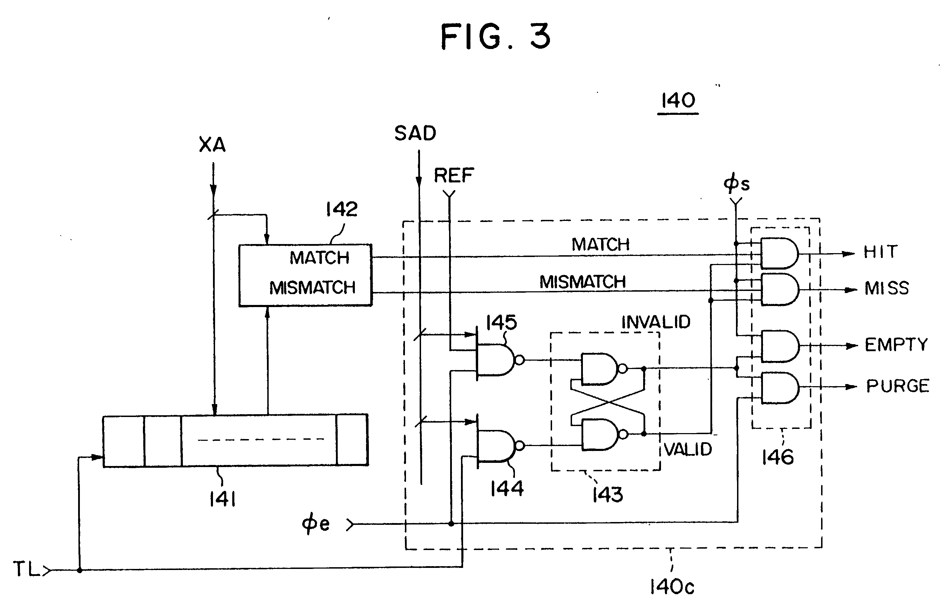

Fig. 3 is a block diagram illustrating the TAG block shown in Fig. 1. The TAG block incorporates therein a TAG address holding circuit 141 for loading the lower bits of the input X address in response to a TAG load signal TL and holding as the TAG address, an address comparison circuit 142 for outputting either a "Match" or "Mismatch" signal by comparing the TAG address with lower bits of a newly input X address, and a block control circuit 140C for controlling each TAG blocks.

Each block control circuit 140C respectively employs a TAG flag 143 which holds either valid or invalid state of the TAG address. A signal from the sub-array selection line and a TAG load signal TL are input through a gate 144 to a reset terminal of the TAG flag 143.

Judgement is made at a gate 146 among timing signals Φe and Φs, the output signal from the TAG flag 143, and the output signal from the address comparison circuit 142 and the gate 146 outputs "HIT", "MISS", "EMPTY" or "PURGE" as a TAG judgement signal.

In commencing each operations at the control unit, the TAG judgement signal "HIT" is output when "Match" and "Valid" state is satisfied, "MISS" is output when "Mismatch" and "Valid" state is satisfied, and "EMPTY" is output when "Invalid" state is satisfied notwithstanding either "Match" or "Mismatch". In completion of each operations, the TAG judgement signal "PURGE" is activated to be output when "Invalid" state is satisfied.

Now, a brief description of the operation will be made as to the circuit shown in Fig. 1.

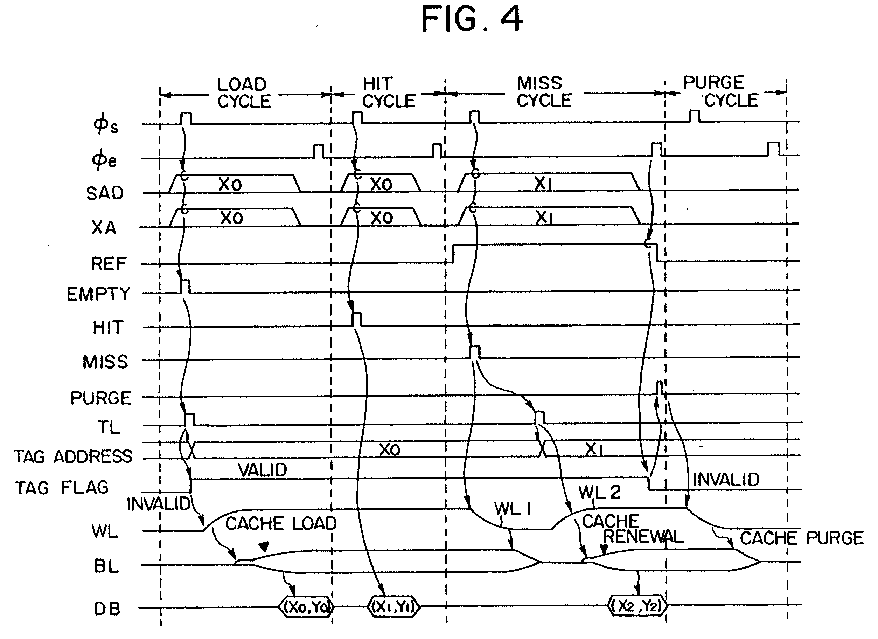

Fig. 4 is a time chart illustrating an operation of the DRAM shown in Fig. 1. The operation of the DRAM shown in Fig. 1 will be described hereunder in reference to Fig. 4.

At the initial stage of each operational cycles, one set in combination of mutually related sub-array 110ⱼ, TAG block 140ⱼ and sub-array control circuit 150ⱼ is selected by the sub-array address among each of the sub-arrays 110ⱼ, the TAG blocks 140ⱼ and the sub-array control circuits and activated, respectively.

Each waveforms in Fig. 4 relates to the sub-array 110ⱼ activated by the sub-array address and to the TAG block 140ⱼ.

There are four principal operational states in the DRAM shown in Fig. 1, which are (1) Load cycle, (2) Hit cycle, (3) Miss cycle, and (4) Purge cycle. In addition, even though there exists Nop cycle where only the other sub-array is activated but no change occurs at the instant sub-array, further explanation will be omitted.

### (1) Operation in Load cycle

At the beginning of the cycle, the word lines WL are reset, the bit lines BL are equalized, and the TAG flag 143 (see Fig. 3) outputs "Invalid".

Accordingly, if the sub-array address SAD and the X address bus XA are defined, the TAG judgement signal "EMPTY" is activated to commence the load cycle notwithstanding the state of the TAG address. The sub-array control circuit 150ⱼ transmit the TAG load signal TL to the TAG blocks 140ⱼ in response to the TAG judgement signal "EMPTY" and load information on the X address bus into the X decoders 110ⱼ. As a result, the TAG address is stored in the TAG address holding circuit 141 (see Fig. 3) in the TAG blocks 141ⱼ and the X address is stored in the X decoders 110ⱼ, respectively. The X decoders 110ⱼ decode the input X address to selectively activate the word lines WL so that a read-out voltage can appear on the bit lines BL. Consequently, the sense amplifier caches 120ⱼ are activated by the sub-array control circuit 150ⱼ. Data from the bit lines BL are amplified and restored in the sense amplifier caches 120ⱼ. Further operations after the cache loading will be similar to the well-known page mode operation of the DRAM.

In the activated sense amplifier caches 120ⱼ, when Y address is defined, the column access operation will be performed to the sense amplifier designated by a column line CL. In other words, data are read or written through the data bus DB in response to the control of the column line CL.

### (2) Operation in Hit cycle

At the beginning of the cycle, the word lines WL are set, the TAG flag 143 is "Valid", the TAG blocks 140ⱼ hold the TAG address, the X decoders 110ⱼ hold the X address obtained in the preceding access, and the sense amplifier caches 120ⱼ hold the data obtained in the preceding access, respectively.

On this instance, when the sub-array address SAD and the X address bus XA are defined, the address comparison circuit 142 (see Fig. 3) compares the TAG address with the information in the X address bus XA. If the both informations coincide with each other, the TAG judgement signal "HIT" is activated to run the hit cycle.

Further operations, though omitted in Fig. 4, will be done as follows.

The column access operation is performed under conditions where each states are maintained as they are without change in the TAG blocks 140ⱼ and the sub-arrays 100ⱼ.

### (3) Operation in Miss cycle

The initial state of the cycle is similar to that of (2) the hit cycle. On this instance, when the sub-array address SAD and the X address are defined, the address comparison circuit 142 compares the TAG address with the information in the X address bus XA. If the both informations do not coincide with each other, the TAG judgement signal "MISS" is activated to run the miss cycle. The sub-array control circuit 150ⱼ purge, in response to the TAG judgement signal "MISS", the X address stored in the X decoders 110ⱼ and reset the word lines WL₁. Consequently, the sense amplifier caches 120ⱼ are inactivated in response to the TAG judgement signal "MISS" so that the data latched in the sense amplifier caches 120ⱼ are purged and the bit lines BL are equalized.

After that, the sub-array control circuit 150ⱼ transmit the TAG load signal TL to the TAG blocks 140ⱼ.

The TAG blocks 140ⱼ store, in response to the TAG load signal TL, new X address bus informations as the TAG address into the TAG address holding circuit 141. On the other hand, the X decoders 110ⱼ store new X address bus informations. As a result, the informations stored in the TAG blocks 140ⱼ and the X decoders 110ⱼ are renewed. Then, a new word line WL₂ selected by the X decoders 110ⱼ is set so that the read out voltage is generated on the bit line BL. Consequently, the sense amplifier caches 120ⱼ are activated again by the sub-array control circuit 150ⱼ and the voltage on the bit line BL is amplified and restored. In other words, data stored in the sense amplifier caches 120ⱼ are renewed. After that, an unillustrated column access operation will be performed.

### (4) Operation in Purge cycle

If the preceding cycle was the refresh operation, the purge cycle is initiated after completion of the operation.

The purge cycle shown in Fig. 4 illustrates an example in which the miss cycle shown in Fig. 4 was the refresh operation. As shown in Fig. 4, if the miss cycle is the refresh operation, a refresh signal REF (see Fig. 3) has been activated during a cycle period. At the end of the cycle, the TAG flag 143 (see Fig. 3) outputs "Invalid" when the timing signal Φe is activated. The TAG judgement signal "PURGE" is activated at the gate 145 in response to the "Invalid" signal. The sub-array control circuit 150ⱼ perform the purge to the TAG memory 140 and the sense amplifier caches 120ⱼ in the next cycle in response to the TAG judgement signal "PURGE". However, in the present embodiment, the information itself stored in the TAG memory 140 needs not to be reset because the TAG flag 143 has already been "Invalid". Accordingly, only sense amplifier caches 120ⱼ are purged.

The circuit state at the beginning of the purge cycle remains the same as that at the beginning of the hit cycle. When the purge cycle is initiated, the sub-array control circuit 150ⱼ purge the stored information of the X decoders 110ⱼ and reset the word line WL₂ already selected before the purge cycle. Consequently, the sub-array control circuit 150ⱼ inactivate the sense amplifier caches 120ⱼ in accordance with the TAG judgement signal "PURGE" and equalize the bit line BL. In other words, data latched in the sense amplifier caches 120ⱼ are purged.

As described above in the present embodiment, the TAG memory and the sense amplifier cache are controlled so as to perform a high speed access operation.

The present embodiment has further following advantages.
(a) There are provided the TAG blocks 140ⱼ in correspondence with the sub-arrays 100ⱼ which are activated during the access operation including the refresh operation so that only the TAG block corresponding to the refreshed sub-array among the sub-arrays 100ⱼ is purged. In other words, the TAG memory is not unnecessarily purged so that even if the column sense amplifier is utilized as a cache, a chip size can be reduced with keeping a high hit rate.
(b) Since the sense amplifier cache corresponding to the refreshed sub-array is purged in the next cycle, the word line WL and the column sense amplifier need not to be reset once again even when the instant sub-array is selected at the successive access operation. As a result, an access time at the miss operation can be reduced.
(c) There is, in general, no relation between the addresses at the refresh operation and at the external access operation so that almost every access results into miss access when the refreshed sub-array is again selected in the next access operation. Accordingly, an average mean value of the access time can be reduced by reducing the access time at the miss operation described in the paragraph (b).
(d) At the waiting, the sense amplifier caches 120ⱼ are successively purged accompanied with the refresh operation so that the sense amplifier caches 120ⱼ become inactive and the bit line BL is equalized during the prescribed refresh period. Accordingly, a waiting current caused by a sub-threshold current can be reduced as compared with that of the conventional DRAM in which the bit line BL is waiting with a full swing state without the sense amplifier cache be purged.
(e) Judgement as to "HIT" or "MISS" of the TAG memory can be done by only utilizing the X address so that there is no need to define the Y address even when the address multiplexer type system is constructed. As a result, the word line WL of the sub-array can be initiated to reset faster at the miss operation than the conventional DRAM can, which may realize the reduction of the access time.

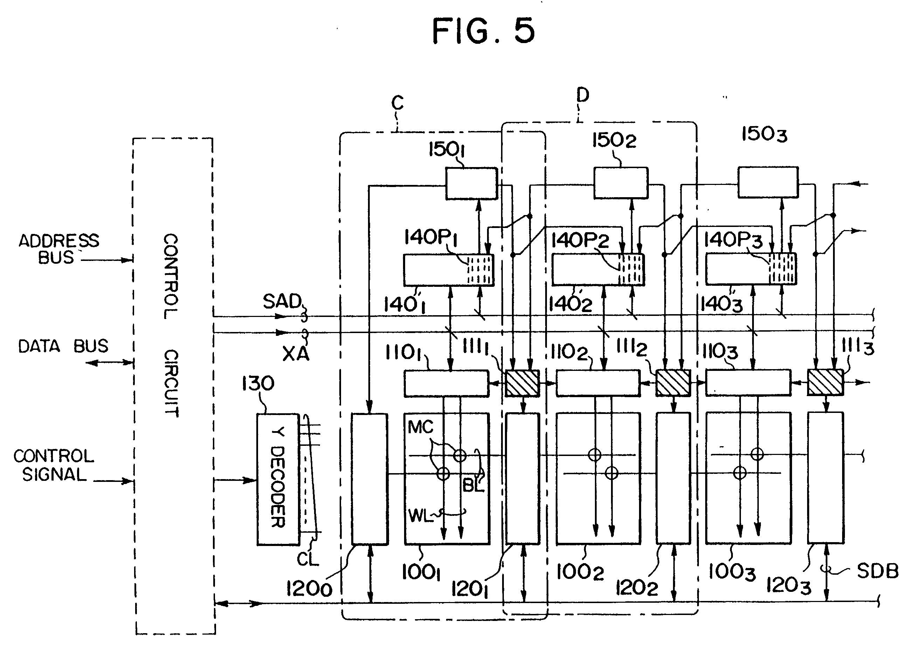

The present invention cannot be limited to the first embodiment but various kinds of modifications can be done. These modifications and variations are, for example, as follows:
(A) Plural sets of the sub-array and the TAG block can be concurrently activated at the access time including the refresh operation. On this instance, the set of the activated sub-array and the TAG block receives the same X address and is controlled in the same manner. For example, two dot lines in Fig. 1 show a control unit B concurrently accessed with the control unit A. The control unit B is constituted of the sub-array, the same amplifier cache, the X decoder and the sub-array control circuit, and is controlled by various signals from the common TAG block 140₁. To employ such a structure can realize the DRAM in which input/output operation with multi-bits can be performed.
(B) If possible in layout configuration, there can employ such a structure that one set of the TAG block and the sub-array control circuit can concurrently activate plural sets of the sub-array and the TAG block at the access time including a refresh. As a result, the word line WL and the bit line BL, both of which have a large amount of parasitic capacitance, are divided so that the high speed operation can be realized.
(C) It can be controlled in such a manner that at the normal access time, each of plural sets of the sub-array and the TAG block is activated with a separate cycle and at the refresh operation time, is activated concurrently, thereby holding the TAG address with a number of the sub-arrays notwithstanding refresh specifications. Accordingly, a sufficient entry number of the TAG memories can be obtained, which causes to improve the hit rate.
(D) A shared sense amplifier system in which the sense amplifier cache is mutually shared by the adjacent sub-arrays can be employed. Fig. 5 is a block diagram illustrating the case in which the shared sense amplifier system is employed.

The shared sense amplifier system is constructed such that adjacent control units C and D, which are similar to the control unit A, share the sense amplifier 120 with each other so that the control units C and D incorporate therein a sense amplifier mediation circuit 111 which validates one output signal and invalidates another output signal among the outputs from the mutually adjacent sub-array control pair circuit 150.

In other words, the DRAM in accordance with the present system employs a mediation circuit 111 which validates either one of the mutually adjacent sub-array control circuit 150 and invalidates the other in each sense amplifier caches 120 and a purge circuit 140P disposed in the block control circuit in each TAG block 140 and detects as to whether the adjacent sub-array is activated or not and purges the content of the TAG block.

To employ the shared sense amplifier system can further realize the DRAM with a smaller chip size.

### Second Embodiment

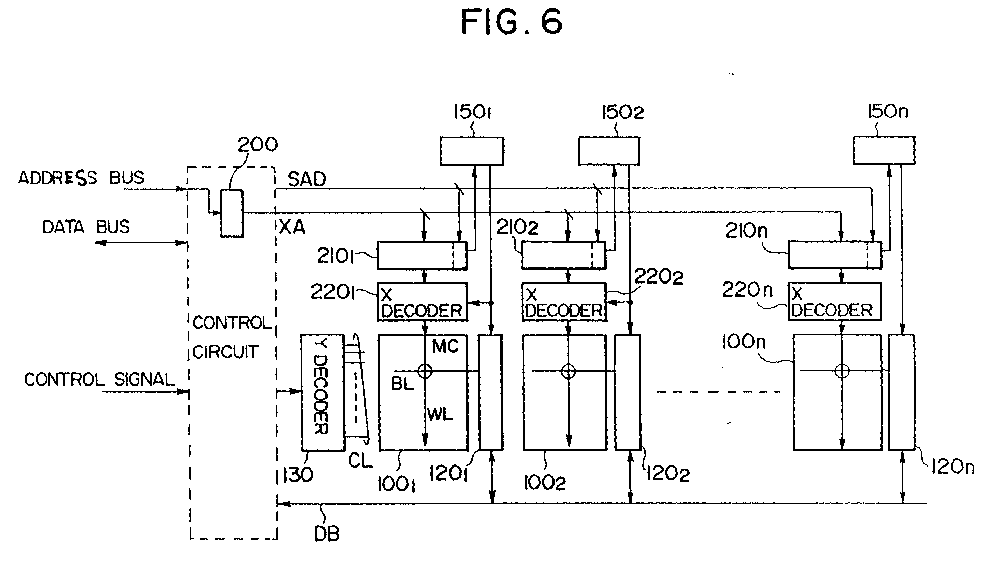

Fig. 6 is a block diagram illustrating the second embodiment according to the present invention which incorporates a TAG block 210 thereinto different from the TAG block 140 shown in Fig. 1.

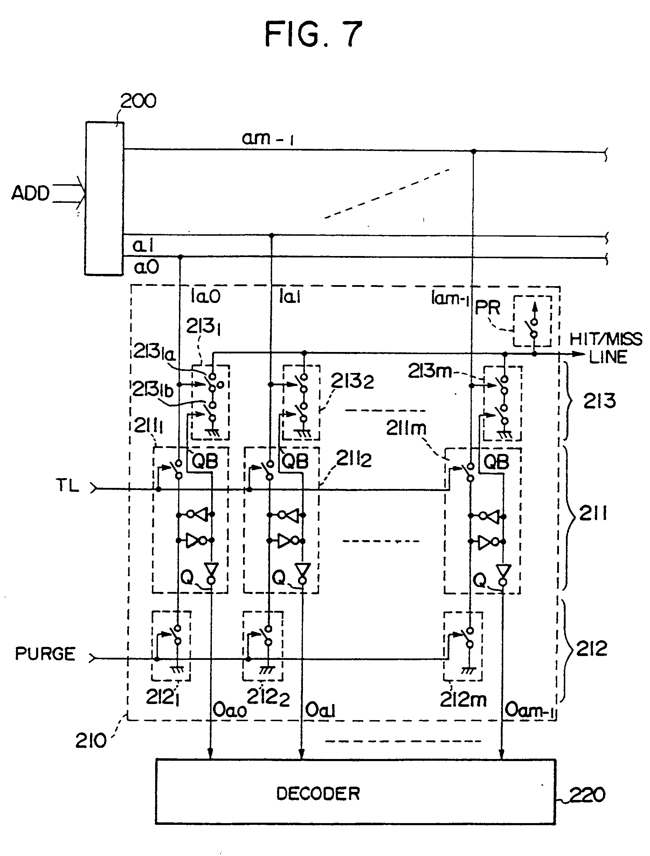

Fig. 7 is a detailed circuit diagram of the TAG block 210 shown in Fig. 6 in which are shown the first decoder circuit 200 for outputting an intermediate address obtained by predecoding an address ADD through intermediate address buses a₀, a₁, ···, aₘ₋₁, a TAG block 210 for loading and holding the intermediate addresses, and the second decoder circuit 220 for decoding the address and selecting the memory cell. The intermediate address buses a₀, a₁, ···, aₘ₋₁, are connected with each of the input terminals Ia₀, Ia₁, ···, Iaₘ₋₁ of the plural TAG blocks 210, respectively and each of the output terminals Oa₀, Oa₁, ···, Oaₘ₋₁ is connected with the decoder circuit 220. The TAG block 210 incorporates therein a control circuit having an equivalent function to the block control circuit 140C shown in Fig. 3 which outputs a signal indicating "EMPTY" or the like.

As shown in Fig. 7, each TAG block 210 has the address input terminals Ia₀, Ia₁, ···, Iaₘ₋₁ with a bus width of the intermediate address buses a₀, a₁, ···, aₘ.

There are also provided plural TAG address holding circuits 211ⱼ for holding the TAG address, plural purge circuits 212ⱼ for purging stored addresses in the TAG address holding circuits 211ⱼ and plural address comparison circuits 213ⱼ, all of which are respectively connected with the address input terminals Ia₀, Ia₁, ···, Iaₘ₋₁.

Each TAG address holding circuits 211ⱼ has an output terminal Q through which the stored information is output, and an output terminal QB through which the stored information is invertedly output, respectively. The output terminal Q of each TAG address holding circuits 211ⱼ is respectively connected with the holding address output terminals Oa₀, Oa₁, ···, Oaₘ₋₁.

The input terminal pair of each address comparison circuits 213ⱼ is respectively connected with the address input terminals Ia₀, Ia₁, ··· Iaₘ₋₁ and the output terminals QB of the TAG address holding circuits 211ⱼ. In other words, the input terminal pair of the i-th address comparison circuit 213ᵢ is connected with the input terminal Iaᵢ₋₁ and the output terminal QB of the TAG address holding circuit 211ᵢ. The output terminals of the address comparison circuits 213ⱼ are commonly connected with a HIT/MISS line together with a precharge circuit PR. Although each TAG blocks 210 includes a control circuit therein which controls the block, description thereof is omitted. Further, switch circuit included in the purge circuits 212ⱼ or the like can be realized, for example, by employing a MOSFET a gate of which is connected with control line thereof.

Now, an operation is described as to the DRAM shown in Fig. 7. Each address holding circuits 211ⱼ in one TAG block 210 serves as the TAG address holding circuit 211 which stores one set of the TAG address.

Similarly, each address comparison circuits 213ⱼ serves as the address comparison circuit 213 for one TAG block whereas each purge circuits 212ⱼ serves as one purge circuit 212. At the initial stage of each operational cycles of the DRAM, the HIT/MISS line is charged up to "H" level by the precharge circuit PR.

When the address is defined, the decoder circuit 200 predecodes the address ADD to obtain the intermediate address which is output to the intermediate address buses a₀, a₁, ···, aₘ₋₁.

Subsequently, in the TAG block corresponding to the sub-array which will be activated, the address comparison circuit 213 compares the TAG address with the intermediate address.

The present embodiment works in such a manner that if the both addresses coincide with each other, the HIT/MISS line reveals "H" level. For example, if the intermediate address a₀ and the corresponding address holding circuit 211₁ are both "H" levels, the output QB reveals "L" level. As a result, one of the switch, for example NMOS Transistor, 213₁ₐ of the address comparison circuit 213₁ turns on and the other switch, for example NMOS Transistor, 213_{1b} turns off.

As described above, if each bits of the intermediate address is identical to the stored information of each corresponding address holding circuit, at least one of the two switch elements connected in series to constitute each address comparison circuit turns off so that the HIT/MISS line stays precharged, thereby keeping "H" level. If both the TAG address and the intermediate address do not coincide with each other, there necessarily exists the bit i in which the stored information of the address holding circuit 211ᵢ corresponding to one of the intermediate address bits (aᵢ) revealing "H" level reveals "L" level. On this instance, the output QB of the address holding circuit 211ᵢ becomes "H" level, which causes both two switch elements connected in series in the address comparison circuit 213ᵢ to turn on.

As a result, electric charge on the HIT/MISS line will be discharged through the address comparison circuit 213ᵢ, thereby the level to become "L" level.

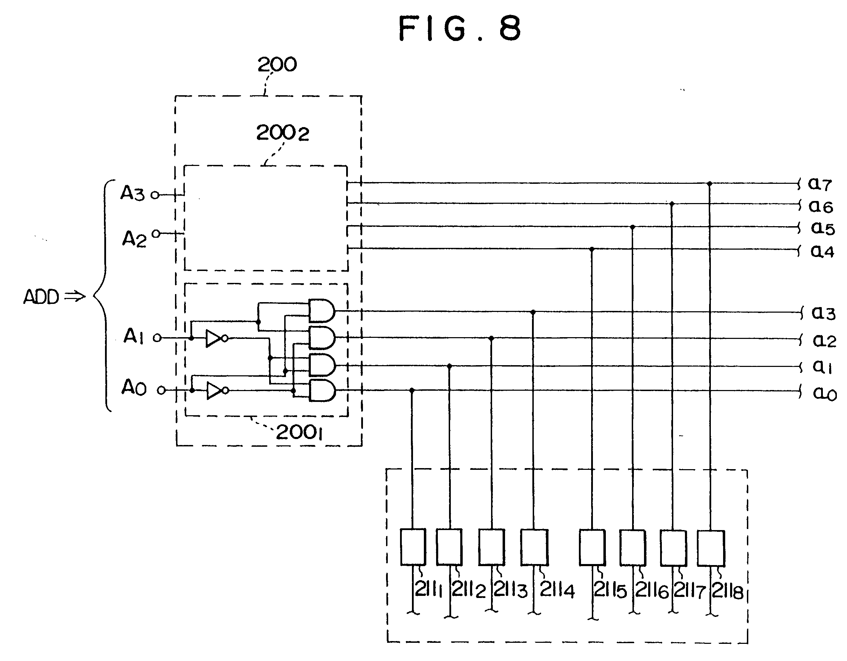

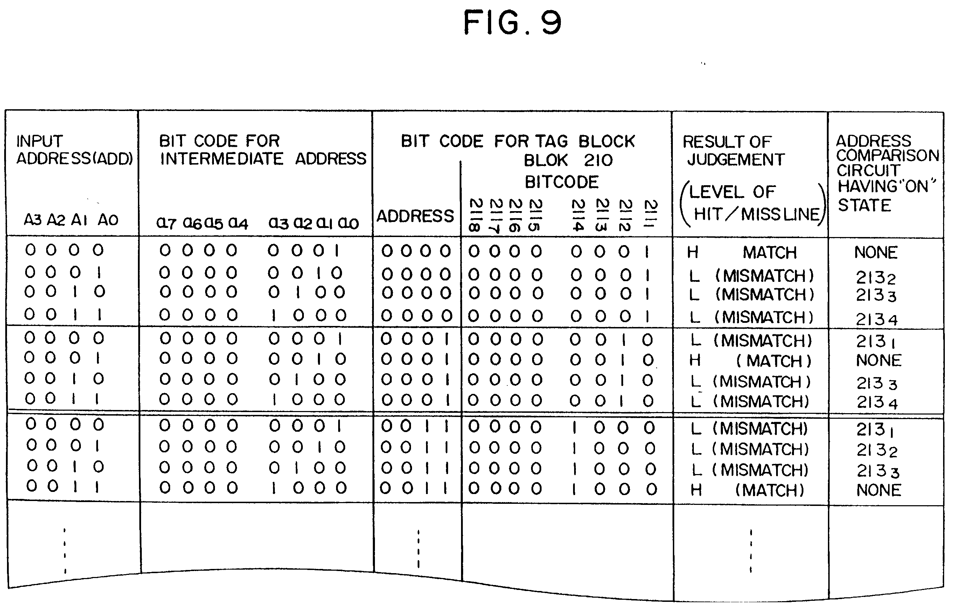

Now, referring to Figs. 8 and 9, explanation will be made as to the ground why there necessarily exists the bit i in which the stored information of the address holding circuit 211ᵢ corresponding to one of the intermediate address bits (aᵢ) revealing "H" level reveals "L" level, if both the TAG address and the intermediate address do not coincide with each other.

Fig. 8 is a circuit diagram illustrating one concrete example of the first decoder circuit shown in Fig. 7.

Although Fig. 8 illustrates, for the benefit of the better understanding of the present embodiment, that the first decoder circuit 200 is constituted of two 2 bit to 4-line decoders 200₁ and 200₂, the actual circuit may be constituted of much more 2 bit to 4-line decoders.

The first decoder circuit 200 can also be constructed so as to include a decoder having a different structure like 8 bit to 8 line decoder.

Fig. 9 is a true/false logic table applied to Fig. 8 when the intermediate address is "H" active. Since the logic table applied to Fig. 8 actually illustrates 16 × 16 (= 256) values, a partial chart is shown in Fig. 9. Since the decoder circuit 200 employs a circuit configuration shown in Fig. 8, each bit code values for the intermediate address of the input address ADD is shown in Fig. 9 as a₀ ∼ a₇.

Accordingly, as shown in the result of judgement of Fig. 9, if the HIT/MISS line reveals "Mismatch", the TAG address holding circuit 211ⱼ, which corresponds to the bit aⱼ, an intermediate address of which reveals "H" level, necessarily holds "L" level and the second address comparison circuit 213ⱼ becomes conductive so that a detection as to whether the TAG address matches or mismatches with the TAG address can be made in the TAG block 210.

According to the present embodiment, if the bit code for the address ADD changes from the previously accessed code, the bit code for the intermediate address changes so that one of the address comparison circuit 213 becomes conductive, thereby causing the output to be "MISS". On the other hand, if the bit code for the address ADD remains the same as that on the preceding access, the address comparison circuit 213 outputs "HIT". When "HIT", each circuits of the DRAM stays with the same state as it is and the column access operation will be performed. When "MISS", the load signal TL shown in Fig. 7 is activated so that the bit codes on the intermediate address buses a₀, a₁, ···, aₘ₋₁ are loaded into the TAG address holding circuit 211. In the refresh operation, the purge signal PURGE is activated at the end of the cycle so that the purge circuit 212 resets the TAG address. As a result, all of the address output terminals Oa₀, Oa₁, ···, Oaₘ₋₁ of the TAG block 210 are inactivated. On the other hand, there exists no address ADD all of which are predecoded into an inactive bit code so that when the TAG block 210 and the corresponding sub-array would be activated again, the address comparison circuit 213 always outputs "MISS".

As described above, even though the decoder and the TAG memory are constructed such that the predecoded intermediate address must be input, judgement can be made as to "HIT" or "MISS" occurred in the TAG.

Accordingly, the sense amplifier can be controlled as a cache by employing an adequate number of the sub-array control circuit.

The DRAM according to the present embodiment constructed above has the following advantages.
(f) Since the TAG memory receives the predecoded intermediate address, there is less restriction for its allocation so that even though it is allocated, for example, adjacent to the X decoder, no extra wirings are required, which reduces the chip size.
(g) A number of bits for the TAG memory will increase as compared with the conventional one if comparison is made on the TAG memory itself. However, there is employed the structure that the output of the address holding circuit 211 is input to the second decoder circuit 220 so that the X decoder does not require the storing circuit therein which was required, for example, in the first embodiment. As a result, in the system which requires to hold the address while setting the word line WL in accordance with the TAG address, the total circuit size can be more reduced as compared with the case where the conventional TAG memory is utilized.
(h) Since the TAG address holding circuit 211 generally serves as a buffer to the second decoder circuit 220 having a large amount of input capacitance, duty for the intermediate address buses a₀, a₁, ···, aₘ₋₁ can be reduced, thereby to provide the high speed DRAM.

The second embodiment is also not limited to be applied to the structure shown in Fig. 6.

Another modified structure will be shown hereinbelow.
(E) Fig. 10 is a block diagram illustrating that the shared sense amplifier system is applied to the second embodiment.

In this embodiment, as similar to the control units C and D shown in Fig. 5, both a control unit E and an adjacent control unit F share the sense amplifier 120.

Such above the structure requires in the control units E and F a sense mediation circuit 111 which validates one of the outputs and invalidates the other among the outputs from the mutually adjacent sub-array control pair 150. To employ the shared sense amplifier system can further realize the DRAM with a small chip size.

Fig. 11 is a block diagram illustrating an example structure of the TAG block 140' in Fig. 10.

As illustrated in the drawing, the TAG block 140' according to the shared sense amplifier system employs an OR circuit 147 which receives an activation signal 147a for activating the adjacent right sub-array, a refresh signal 147b and an activation signal 147c for activating the adjacent left sub-array.

The output of the OR circuit 147 is input to one of the input terminals of a NAND circuit 145. The other input terminal of the NAND circuit 145 receives a timing control signal φé whereas the other input terminal of an AND gate which outputs "PURGE" receives another timing control signal φe.

Further, the output indicating "Valid" among the outputs from the TAG flag 143 is supplied to both adjacent sub-arrays as the sub-array activation signal. The configuration of the TAG block 140' shown in Fig. 11 can be applied to the shared sense amplifier system shown in Fig. 5.

### Third Embodiment

Fig. 12 illustrates the third embodiment of the present invention in which a layout example of the DRAM according to the present invention is shown.

The minimum requirement for the layout according to the present invention, including the first and second embodiments, is to arrange each TAG block 341 in the corresponding TAG memory 340 adjacently to the X decoder disposed in each sub-array 320 as shown in Fig. 12.

Fig. 12 shows the DRAM all components of which are disposed on the same single chip 300. In the left region, there are provided sub-arrays 310ⱼ and 320ⱼ each having a plurality of memory cells which are respectively connected with the cross points between a plurality of word lines and bit lines, word line drivers 311ⱼ corresponding to each sub-arrays, sense amplifier caches 312ⱼ and 322ⱼ which also work as caches in correspondence with each sub-arrays, an X decoder group 330 for decoding the X address, a TAG memory 340, a control circuit 350 including a plurality of sub-array control circuit and two Y decoders 361 and 362 for decoding the Y address.

In the right region of the chip 300, the identical circuit is provided in the same manner symmetrically to the left region. There are provided in the control circuit 350 a plurality of the identical sub-array control circuit 351 and provided in the TAG memory 340 a plurality of the TAG blocks 341.

There are also provided in the X decoder group 330 a plurality of the identical X decoders 331. In the DRAM as shown in Fig. 12, the intermediate address bus XADD obtained by predecoding the X address is wired at approximately the intermediate location of the shortened leg along the longitudinal direction and the TAG memory 340 is disposed along the intermediate address bus XADD.

The X decoder group 330 is disposed adjacent to and in parallel with the TAG memory 340. In the TAG memory 340, the TAG blocks 341 storing one set of the TAG address are arranged along the longitudinal direction of the chip, whereas in the TAG block 341, circuits corresponding to each bits of the address are also arranged along the longitudinal direction.

The control circuit 350 is arranged along the intermediate address bus XADD at the opposite side to the TAG memory 340.

A plurality of sub-arrays is disposed at both outsides of the region where the TAG memory 340 and the X decoder group 330 are arrayed. The sub-arrays 310ⱼ are located at the upper side whereas the sub-arrays 320ⱼ are located at the lower side as shown in Fig. 12.

Between each sub-arrays and the X decoder group 330, there are provided word line drivers 311ⱼ and 321ⱼ corresponding to each sub-arrays in a manner to correspond to each sub-arrays. Sense amplifier caches 312ⱼ and 322ⱼ are also disposed corresponding to each sub-arrays. Portions illustrated with oblique lines in Fig. 12 show the sub-arrays to be concurrently activated in the access operation. In other words, there are provided the sets of the sub-arrays which are concurrently accessed at both outsides of the X decoder group 330. For example, both of the sub-arrays 310₁ and 320₁ are concurrently accessed.

Now, explanation will be made as to a wiring example in the chip 300.

Wirings connecting between the intermediate address bus XADD and each TAG block 341 in the TAG memory 340 and between each TAG block 341 and each circuit block 331 in the X decoder group 330 are formed with the first conductor. Wirings connecting between the intermediate address bus XADD and the longitudinal direction of the chip in the TAG memory 340 and the X decoder group 330 are formed with the second conductor. Wirings connecting between each circuit block 331 in the decoder group 330 and each word line drivers 311ⱼ and 321ⱼ are formed with the third conductor.

Above described embodiment has following advantages.
(i) The TAG block 341 in the TAG memory 340 is located adjacent to each X decoder 331 which corresponds to each TAG block 341 so that there is no need to provide useless and lengthy wirings for connecting therebetween, which minimizes the wiring length. As to wirings between each TAG block 341 and the corresponding sub-array control circuit 351, there is also no need to provide useless and lengthy wirings for connecting therebetween, which also minimizes the wiring length.
   Accordingly, increase of the chip size due to wirings can be prevented.
(j) Under the "MISS" operation in which the sub-array control circuit initiates the operation in accordance with the result of judgement by the TAG memory, a delay of the access time for the DRAM can be reduced on grounds set forth in paragraph (i).
(k) Since a set of the sub-arrays concurrently activated is disposed outsides of the TAG memory 340 and the X decoder group 330 and arrayed opposing with each other, the set of the sub-arrays can be commonly controlled by one set of the TAG block 341 and the X decoder 331, thereby reducing the sizes of the TAG memory 340 and the X decoder group 330.
(ℓ) Each word line drivers 311ⱼ and 321ⱼ is disposed respectively corresponding to each sub-arrays 310ⱼ and 320ⱼ so that in case of charge or discharge a large amount of parasitic capacitance on the word line WL, noises on a power line can be diversified and reduced. Moreover, since each word line drivers employs the gate circuit, X redundant cells can be replaced independently from the upper side sub-arrays on the lower side sub-arrays, which contributes to improve yielding.

Further, at the time of "Miss" access, the operation to reset the missed sub-array and the operation to decode a new X address can be performed with partially or completely overlapping timing.

The layout of the DRAM according to the present invention cannot be limited to the pattern particularly illustrated in Fig. 12. In other words, the minimum requirement for the layout according to the present invention is, as described before, to dispose each corresponding TAG blocks 341 in the TAG memory 340 adjacent to the X decoders for each sub-arrays 320. Accordingly, any layout is acceptable to satisfy the above conditions. Figs. 13 and 14 show examples of the layout satisfying such conditions.

It may happen to be desirable from the view point of speed to employ a package, in which the DRAM is embedded, which has bonding pads arrayed only along one of the longitudinal legs of the chip.

Fig. 13 shows an example of the layout satisfying such above in which the control circuit 350, the TAG memory 340, the X decoder group 330 and the like are collectively disposed at the end of one of the longitudinal legs of the chip.

In Fig. 14, each sub-arrays 310 and 320 are disposed along the longitudinal leg of the chip. On this instance, the X decoder group 330 may be commonly disposed to each word line drivers 321₁ₐ, 321_{1b}, ···, of the sub-arrays 320₁ₐ, 320_{1b}, ··· arranged along the longitudinal leg of the chip and may be connected with the main word line MWL which is wired as an upper wiring on the sub-array. As described above in details, since the TAG memory according to the embodiment shown in Fig. 1 is constructed such that at least one TAG block, which stores one set of TAG addresses for the sub-arrays concurrently activated, is disposed to be plurally arrayed, the number of the TAG blocks purged at the time of refreshing can be minimized. Accordingly, the DRAM with a high hit rate can be realized with the chip size being maintained small.

Further, since the TAG memory operates in such a manner to judge "Hit" or "Miss" without waiting the definition of the Y address, a delay of the access time can be reduced, for example, in the DRAM which employs an address multiplier type interface.

If a structure is employed in which the sense amplifier utilized as a cache is purged after refreshed, a waiting current in the waiting period can be reduced.

Further reduction of the chip size can be realized if a structure of the DRAM is employed shown in Figs. 5 and 8 in which adjacent sub-arrays share the sense amplifier cache with each other.

In the DRAMs shown in Figs. 6 and 7, the TAG memory inputs the predecoded intermediate addresses so that restriction against the pattern layout is released. Even though the TAG memory is disposed, for example, adjacent to the X decoder, no increase occurs in its occupying area notwithstanding the wiring so that the total chip size can be reduced.

Further, since the TAG memory serves as a buffer for the decoder circuit, a high speed operation can be accomplished.

Since the DRAM shown in Fig. 9 employs such a structure that the X decoder and the TAG memory are disposed adjacently and in parallel with each other at the central region of the chip and a plurality of sub-arrays concurrently accessed is disposed with facing each other at the both outsides of the region where the X decoder and the TAG memory are allocated, the chip size can be reduced.

Moreover, various kinds of wirings can be shortened so that a high speed DRAM can be realized.

## Claims

1. A dynamic RAM comprising:
(a) a plurality of sub-arrays (100₁, ..., 100ₙ; 310₁, 320₁, ..., 310ₙ, 320ₙ) having a plurality of memory cells (MC), each of the memory cells (MC) being connected with each of cross points between a plurality of word lines (WL) and bit lines (BL);
(b) an X decoder (110₁, ..., 110ₙ; 220₁, ..., 220ₙ; 320) for decoding an X address in an X address bus (XA) and selecting the word line (WL);
(c) a column sense amplifier (120₁, ..., 120ₙ) for detecting and amplifying data on the bit line (BL) read out from the memory cell (MC);
(d) a sub-array control circuit (150₁, ..., 150ₙ) for controlling the column sense amplifier (120₁, ..., 120ₙ) as a cache;
characterized by
(e) a TAG memory (140; 340) having a plurality of TAG blocks (140₁, ..., 140ₙ; 210₁, ..., 210ₙ; 140'₁, ..., 140'ₙ 341), each of the TAG blocks (140₁, ..., 140ₙ; 210₁, ..., 210ₙ; 140'₁, ..., 140'ₙ; 341) storing a TAG address assigned to the sub-arrays concurrently activated at a time of access, for inputting an address having a logically equivalent value to that of the X address, wherein the X decoder and the TAG memory are located adjacently and in parallel with each other on the chip, the corresponding TAG blocks being disposed adjacent to the X decoders prepared for each sub-arrays.

2. A dynamic RAM as set forth in claim 1, wherein each of the TAG blocks (140₁, ..., 140ₙ) employs a control circuit (150₁, ..., 150ₙ) which purges the TAG block (140₁, ..., 140ₙ) and the column sense amplifier (120₁, ..., 120ₙ) corresponding to the sub-arrays (100₁, ..., 100ₙ) after completion of refreshing to the sub-arrays (100₁, ..., 100ₙ).

3. A dynamic RAM as set forth in claim 1, wherein a plurality of sets of the sub-array and the TAG clock is concurrently activated at the time of access including refresh and the same X address is input for performing the same control into the activated set of the sub-array and the TAG block.

4. A dynamic RAM as set forth in claim 1, wherein a plurality of sets of the sub-array and the TAG block is activated with each separate cycles at the time of access and activated concurrently at the time of refresh.

5. A dynamic RAM as set forth in claim 1, wherein the X decoder (110₁, ..., 110ₙ) and the TAG memory (140₁, ..., 140ₙ) are located at a central region of a chip and a plurality of the sub-arrays (100₁, ..., 100ₙ) concurrently accessed is located at both outsides of the region where the X decoder (110₁, ..., 110ₙ) and the TAG memory (140₁, ..., 140ₙ) are located.

6. A dynamic RAM as set forth in claim 1, wherein the TAG block further comprising:
(a) a TAG address holding circuit (141) for loading and storing lower bits of the X address in response to the TAG load signal (TL);
(b) an address comparison circuit (142) for comparing the TAG address with lower bits of a newly input X address and outputting a signal indicating either "Match" or "Mismatch"; and
(c) a block control circuit (140C) having a TAG flag (143) which stores either valid or invalid state for the TAG address, for inputting the signal indicating either "Match" or "Mismatch" from the address comparison circuit (142), a sub-array address indicating upper bits of the X address, a refreshing signal for refreshing the column sense amplifier (150₁, ..., 150ₙ), and a first and a second timing signals and outputting a signal indicating either "MISS", "EMPTY" or "PURGE".

7. A dynamic RAM as set forth in claim 1,
said sub-array control circuit (150₁, ...., 150ₙ) being disposed in each of the TAG blocks (140'₁, ..., 140'ₙ) for controlling the column sense amplifier (120₁, ..., 120ₙ) as a cache; and
sense amplifier mediation circuit (111) being comprised for validating one and invalidating another output to partial outputs of a pair of the sub-array control circuit (150₁, ..., 150ₙ) mutually arrayed adjacently with each other.

8. A dynamic RAM as set forth in claim 7, wherein each of the TAG blocks (140'₁, ..., 140'ₙ) employs a control circuit (140P₁, ..., 140Pₙ) which detects an activation state of a sub-array adjacent to the sub-array corresponding to the TAG block (140'₁, ..... 140'ₙ) and purges data stored in said TAG block, and detects a refresh operation of a sub-array corresponding to said TAG block and purges data stored in said TAG block when the the refresh operation is completed.

9. A dynamic RAM as set forth in claim 1, comprising
a first decoding circuit (200) for predecoding an address (ADD) and outputting an intermediate address (a₀, ...., aₘ₋₁);
a first intermediate address bus for transmitting the intermediate address; and
said TAG memory being constituted of a plurality of blocks (210₁, ..., 210ₙ) and connected with the first intermediate address bus (a₀, ..., aₘ₋₁);
each blocks (210₁, ..., 210ₙ) of the TAG memory further comprising:
(i) a TAG address circuit (211₁, ..., 211ₙ) for loading and storing the intermediate address and for providing the intermediate address to a second decoding circuit (220);
(ii) an address comparison Circuit (213₁, ..., 213ₙ) for comparing an address on the intermediate address bus (a₀, ..., aₘ₋₁) with a stored address in the TAG address holding circuit (211₁, ..., 211ₙ); and
(iii) a purge circuit (212₁, ..., 212ₙ) for inactivating all bits held by the TAG address holding circuit (211₁, ..., 211ₙ).

10. A dynamic RAM as set forth in claim 9, wherein the RAM is applied to a shared sense amplifier system which shares a sense amplifier cache having a plurality of sub-array control circuits (150₁, ..., 150ₙ) disposed in each the TAG blocks (140'₁, ..., 140'ₙ) for controlling the column sense amplifier (120₁, ..., 120ₙ) as a cache; and a sense amplifier mediation circuit (111) for validating one and invalidating another output to partial outputs of a pair of the sub-array control circuits (150₁, ..., 150ₙ) mutually arrayed adjacently with each other.

11. A dynamic RAM as set forth in claim 1 wherein
the plurality of TAG blocks (341) is holding as a set of TAG addresses an X address for selecting a memory cell of the sub-array (310₁, 320₁, ..., 310ₙ, 320ₙ); and
(c) an X decoder (331) is provided in each of sub-arrays (310₁, 320₁, ..., 310ₙ, 320ₙ) for decoding the X address and selecting the word line (WL); each of the corresponding TAG blocks (341) being located adjacent to the X decoder (331) provided in each sub-arrays (310₁, 320₁, ..., 320ₙ, 320ₙ).

12. A dynamic RAM as set forth in claim 11, wherein a plurality of the sub-arrays (310₁, 320₁, ..., 310ₙ, 320ₙ) is located at both outsides of a region where the TAG memory (340) constituted of a plurality of the TAG blocks (341) and the X decoder group (330) constituted of a plurality of the X decoders (331) are located.

13. A dynamic RAM as set forth in claim 11, wherein a plurality of the sub-arrays (320₁, ..., 320ₙ) is located at one outside of a region where the TAG memory (340) constituted of a plurality of the TAG blocks (341) and the X decoder group (330) constituted of a plurality of the X decoders (331) are located.

14. A dynamic RAM as set forth in claim 11, wherein bit lines (BL) of each the sub-arrays (310₁, 320₁, ..., 310ₙ, 320ₙ) are laid out in such a manner to be located along a longitudinal leg of a semiconductor chip (300).

## Patentansprüche

1. Dynamischer RAM, der folgendes aufweist:
(a) eine Vielzahl von Unterdatenfeldern (1001, ..., 100n; 3101, 3201, ..., 310n, 320n) mit einer Vielzahl von Speicherzellen (MC), wobei jede der Speicherzellen (MC) mit jeder von Kreuzungsstellen zwischen einer Vielzahl von Wortleitungen (WL) und Bitleitungen (BL) verbunden ist;
(b) einen X-Decodierer (1101, ..., 110n; 2201, ..., 220n; 320) zum Decodieren einer X-Adresse in einem X-Adressenbus (XA) und zum Auswählen der Wortleitung (WL);
(c) einen Spalten-Leseverstärker (1201, ..., 120n) zum Erfassen und Verstärken von aus der Speicherzelle (MC) ausgelesenen Daten auf der Bitleitung (BL);
(d) eine Unterdatenfeld-Steuerschaltung (1501, ..., 150n) zum Steuern des Spalten-Leseverstärkers (1201, ..., 120n) als Cache;
gekennzeichnet durch
(e) einen TAG-(=Etikettenkennzeichen)-Speicher (140; 340) mit einer Vielzahl von TAG-Blöcken (1401, ..., 140n; 2101, ..., 210n; 140'1, ..., 140'n; 341), wobei jeder der TAG-Blöcke (1401, ..., 140n; 2101, ..., 210n; 140'1, ..., 140'n; 341) eine TAG-Adresse speichert, die den Unterdatenfeldern zugeordnet ist, die zur Zeit eines Zugriffs gleichzeitig aktiviert sind, zum Eingeben einer Adresse mit einem logisch äquivalenten Wert zu demjenigen der X-Adresse, wobei der X-Decodierer und der TAG-Speicher benachbart und parallel zueinander auf dem Chip angeordnet sind, wobei die entsprechenden TAG-Blöcke benachbart zu den X-Decodierern angeordnet sind, die für jedes Unterdatenfeld vorbereitet sind.

2. Dynamischer RAM nach Anspruch 1, wobei jeder der TAG-Blöcke (1401, ..., 140n) eine Steuerschaltung (1501, ..., 150n) verwendet, die den TAG-Block (1401, ..., 140n) und den Spalten-Leseverstärker (1201, ..., 120n) entsprechend den Unterdatenfeldern (1001, ..., 100n) nach einer Beendigung eines Auffrischens der Unterdatenfelder (1001, ..., 100n) löscht.

3. Dynamischer RAM nach Anspruch 1, wobei eine Vielzahl von Gruppen aus dem Unterdatenfeld und dem TAG-Block zur Zeit eines Zugriffs einschließlich eines Auffrischens gleichzeitig aktiviert ist und dieselbe X-Adresse zum Durchführen derselben Steuerung in den aktivierten Satz aus dem Unterdatenfeld und dem TAG-Block eingegeben wird.

4. Dynamischer RAM nach Anspruch 1, wobei eine Vielzahl von Gruppen aus dem Unterdatenfeld und dem TAG-Block zur Zeit eines Zugriffs bei jeweils separaten Zyklen aktiviert ist und zur Zeit eines Auffrischens gleichzeitig aktiviert ist.

5. Dynamischer RAM nach Anspruch 1, wobei der X-Decodierer (1101, ..., 110n) und der TAG-Speicher (1401, ..., 140n) bei einem zentralen Bereich eines Chips angeordnet sind und eine Vielzahl der Unterdatenfelder (1001, ..., 100n), auf die gleichzeitig zugegriffen wird, an beiden Außenseiten des Bereichs angeordnet ist, wo der X-Decodierer (1101, ...,110n) und der TAG-Speicher (1401, ..., 140n) angeordnet sind.

6. Dynamischer RAM nach Anspruch 1, wobei der TAG-Block weiterhin folgendes aufweist:
(a) eine TAG-Adressen-Halteschaltung (141) zum Laden und Speichern niederwertigerer Bits der X-Adresse in Antwort auf das TAG-Ladesignal (TL);
(b) eine Adressen-Vergleichsschaltung (142) zum Vergleichen der TAG-Adresse mit niederwertigeren Bits einer neu eingegebenen X-Adresse und zum Ausgeben eines Signals, das entweder "Anpassung" oder "Fehlanpassung" anzeigt; und
(c) eine Block-Steuerschaltung (140c) mit einem TAG-Flag (143), das entweder einen gültigen oder einen ungültigen Zustand für die TAG-Adresse speichert, zum Eingeben des Signals, das entweder "Anpassung" oder "Fehlanpassung" anzeigt, von der Adressen-Vergleichsschaltung (142), einer Unterdatenfeld-Adresse, die höerwertigere Bits der X-Adresse anzeigt, eines Auffrischsignals zum Auffrischen des Spalten-Leseverstärkers (1501, ..., 150n) und eines ersten und eines zweiten Zeitgabesignals und zum Ausgeben eines Signals, das entweder "NICHTTREFFER", "LEER" oder "LÖSCHEN" anzeigt.

7. Dynamischer RAM nach Anspruch 1, wobei
die Unterdatenfeld-Steuerschaltung (1501, ..., 150n) in jedem der TAG-Blöcke (140'1, ..., 140'n) zum Steuern des Spalten-Leseverstärkers (1201, ..., 120n) als Cache angeordnet ist; und
wobei eine Leseverstärker-Mediationsschaltung (111) zum für gültig Erklären einer und zum für ungültig Erklären einer anderen Ausgabe zu Teilausgaben eines Paars der Unterdatenfeld-Steuerschaltung (1501, ..., 150n) vorgesehen ist, die wechselseitig zueinander benachbart angeordnet sind.

8. Dynamischer RAM nach Anspruch 7, wobei jeder der TAG-Blöcke (140'1, ..., 140'n) eine Steuerschaltung (140P1, ..., 140Pn) verwendet, die einen Aktivierungszustand eines Unterdatenfelds benachbart zu dem Unterdatenfeld entsprechend dem TAG-Block (140'1, ..., 140'n) erfaßt und im TAG-Block gespeicherte Daten löscht und eine Auffrischoperation eines Unterdatenfelds entsprechend dem TAG-Block erfaßt und im TAG-Block gespeicherte Daten löscht, wenn die Auffrischoperation beendet ist.

9. Dynamischer RAM nach Anspruch 1, der folgendes aufweist:
eine erste Decodierschaltung (200) zum Vordecodieren einer Adresse (ADD) und zum Ausgeben einer Zwischenadresse (a0, ..., am-1);
einen ersten Zwischen-Adressenbus zum Übertragen der Zwischenadresse; und
wobei der TAG-Speicher aus einer Vielzahl von Blöcken (2101, ..., 210n) gebildet ist und mit dem ersten Zwischen-Adressenbus (a0, ..., am-1) verbunden ist;
wobei alle Blöcke (2101, ..., 210n) des TAG-Speichers weiterhin folgendes aufweisen:
(i) eine TAG-Adressenschaltung (2111, ..., 211n) zum Laden und Speichern der Zwischenadresse und zum Liefern der Zwischenadresse zu einer zweiten Decodierschaltung (220);
(ii) eine Adressen-Vergleichsschaltung (2131, ..., 213n) zum Vergleichen einer Adresse auf den Zwischen-Adressenbus (a0, ..., am-1) mit einer gespeicherten Adresse in der TAG-Adressen-Halteschaltung (2111, ..., 211n); und
(iii) eine Lösch-Schaltung (2121, ..., 212n) zum Deaktivieren aller durch die TAG-Adressen-Halteschaltung (2111, . .., 211n) gehaltenen Bits.

10. Dynamischer RAM nach Anspruch 9, wobei der RAM auf ein gemeinsam genutztes Leseverstärkersystem angewendet wird, das einen Leseverstärker-Cache mit einer Vielzahl von Unterdatenfeld-Steuerschaltungen (1501, ..., 150n), die in jedem der TAG-Blöcke (140'1, ..., 140'n) angeordnet sind, zum Steuern des Spalten-Leseverstärkers (1201, ..., 120n) als Cache gemeinsam nutzt; und eine Leseverstärker-Mediationsschaltung (111) zum für gültig Erklären einer und zum für ungültig Erklären einer anderen Ausgabe zu Teilausgaben eines Paars der Unterdatenfeld-Steuerschaltungen (1501, ..., 150n), die wechselseitig zueinander benachbart angeordnet sind.

11. Dynamischer RAM nach Anspruch 1, wobei
die Vielzahl von TAG-Blöcken (341) als einen Satz von TAG-Adressen eine X-Adresse zum Auswählen einer Speicherzelle des Unterdatenfeldes (3101, 3201, ..., 310n, 320n) hält und
ein X-Decodierer (331) in jedem der Unterdatenfelder (3101, 3201, ..., 310n, 320n) zum Decodieren der X-Adresse und zum Auswählen der Wortleitung (WL) vorgesehen ist; wobei jeder der entsprechenden TAG-Blöcke (341) benachbart zum X-Decodierer (331) angeordnet ist, der in jedem Unterdatenfeld (3101, 3201, ..., 310n, 320n) vorgesehen ist.

12. Dynamischer RAM nach Anspruch 11, wobei eine Vielzahl der Unterdatenfelder (3101, 3201, ..., 310n, 320n) an beiden Außenseiten eines Bereichs angeordnet ist, wo der aus einer Vielzahl der TAG-Blöcke (341) gebildete TAG-Speicher (340) und die aus einer Vielzahl der X-Decodierer (331) gebildete X-Decodierergruppe (330) angeordnet sind.

13. Dynamischer RAM nach Anspruch 11, wobei eine Vielzahl der Unterdatenfelder (3201, ..., 320n) an einer Außenseite eines Bereichs angeordnet ist, wo der aus einer Vielzahl der TAG-Blöcke (341) gebildete TAG-Speicher (340) und die aus einer Vielzahl der X-Decodierer (331) gebildete X-Decodierergruppe (330) angeordnet sind.

14. Dynamischer RAM nach Anspruch 11, wobei Bitleitungen (BL) jedes der Unterdatenfelder (3101, 3201, ..., 310n, 320n) auf eine derartige Weise ausgelegt sind, daß sie entlang eines longitudinalen Schenkels eines Halbleiterchips (300) angeordnet sind.

## Revendications

1. Mémoire vive dynamique comprenant :
(a) une pluralité de sous-réseaux (100₁, ... 100ₙ; 310₁, 320₁, ..., 310ₙ, 320ₙ) ayant une pluralité de cellules de mémoire (MC), chacune des cellules de mémoire (MC) étant connectée à chacun des points d'intersection entre une pluralité de conducteurs de mot (WL) et de conducteurs de bit (BL);
(b) un décodeur X (110₁, ..., 110ₙ; 220₁, ..., 220ₙ; 320) pour décoder une adresse X sur un bus d'adresse X (XA), et pour sélectionner le conducteur de mot (WL);
(c) un amplificateur de lecture de colonne (120₁, ... 120ₙ) pour détecter et amplifier des données sur le conducteur de bit (BL) qui sont lues dans la cellule de mémoire (MC);
(d) un circuit de commande de sous-réseau (150₁, ..., 150ₙ) pour commander l'amplificateur de lecture de colonne (120₁, ..., 120ₙ) pour le faire fonctionner comme une antémémoire;
caractérisée par
(e) une mémoire d'étiquette (140; 340) ayant une pluralité de blocs d'étiquette (140₁, ..., 140ₙ; 210₁, ..., 210ₙ; 140'₁, ..., 140'ₙ; 341), chacun des blocs d'étiquette (140₁, ..., 140ₙ; 210₁, ..., 210ₙ; 140'₁, ..., 140'ₙ; 341) stockant une adresse d'étiquette affectée aux sous-réseaux activés simultanément à un moment d'accès, pour introduire une adresse ayant une valeur logiquement équivalente à celle de l'adresse X, le décodeur X et la mémoire d'étiquette étant placés de façon adjacente et parallèlement l'un à l'autre sur la puce, les blocs d'étiquette correspondants étant disposés de façon adjacente aux décodeurs X établis pour chaque sous-réseau.

2. Mémoire vive dynamique selon la revendication 1, dans laquelle chacun des blocs d'étiquette (140₁, ..., 140ₙ) utilise un circuit de commande (150₁, ..., 150ₙ) qui purge le bloc d'étiquette (140₁, ..., 140ₙ) et l'amplificaLeur de lecture de colonne (120₁, ..., 120ₙ) correspondant aux sous-réseaux (100₁, ..., 100ₙ) après l'achèvement de la régénération des sous-réseaux (100₁, ..., 100ₙ).

3. Mémoire vive dynamique selon la revendication 1, dans laquelle une pluralité d'ensembles du sous-réseau et du bloc d'étiquette est activée en même temps au moment de l'accès comprenant la régénération, et la même adresse X est introduite pour accomplir la même commande dans l'ensemble activé du sous-réseau et du bloc d'étiquette.

4. Mémoire vive dynamique selon la revendication 1, dans laquelle une pluralité d'ensembles du sous-réseau et du bloc d'étiquette est activée à chaque cycle séparé au moment de l'accès et est activée en même temps au moment de la régénération.

5. Mémoire vive dynamique selon la revendication 1, dans laquelle le décodeur X (110₁, ..., 110ₙ) et la mémoire d'étiquette (140₁, ..., 140ₙ) sont placés dans une région centrale d'une puce, et une pluralité des sous-réseaux (100₁, ..., 100ₙ) faisant l'objet d'un accès simultané est placée sur les deux côtés extérieurs de la région dans laquelle le décodeur X (110₁, ..., 110ₙ) et la mémoire d'étiquette (140₁, ..., 140ₙ) sont placés.

6. Mémoire vive dynamique selon la revendication 1, dans laquelle le bloc d'étiquette comprend en outre :
(a) un circuit de conservation d'adresse d'étiquette (141) pour charger et stocker des bits inférieurs de l'adresse X en réponse au signal de chargement d'étiquette (TL);
(b) un circuit de comparaison d'adresse (142) pour comparer l'adresse d'étiquette avec des bits intérieurs d'une adresse X nouvellement introduite, et pour émettre un signal indiquant "Concordance" ou "Discordance"; et
(c) un circuit de commande de bloc (140c) ayant un drapeau d'étiquette (143) qui stocke un état valide ou invalide pour l'adresse d'étiquette, pour introduire le signal indiquant "Concordance" ou "Discordance" provenant du circuit de comparaison d'adresse (142), une adresse de sous-réseau indiquant des bits supérieurs de l'adresse X, un signal de régénération pour régénérer l'amplificateur de lecture de colonne (150₁, ..., 150ₙ), et des premier et second signaux de temps, et émettant un signal indiquant "ECHEC", "VIDE" ou "PURGE".

7. Mémoire vive dynamique selon la revendication 1,
le circuit de commande de sous-réseau (150₁, ..., 150ₙ) étant disposé dans chacun des blocs d'étiquette (140'₁, ..., 140'ₙ) pour commander l'amplificateur de lecture de colonne (120₁, ..., 120ₙ) pour le faire fonctionner comme une antémémoire; et
un circuit de médiation d'amplificateur de lecture (111) établi pour valider une sortie et invalider une autre sortie relatives à des sorties partielles d'une paire des circuits de commande de sous-réseau (150₁, ..., 150ₙ) mutuellement disposés de façon adjacente l'un à l'autre.

8. Mémoire vive dynamique selon la revendication 7, dans laquelle chacun des blocs d'étiquette (140'₁, ..., 140'ₙ) utilise un circuit de commande (140P₁, ..., 140Pₙ) qui détecte un état d'activation d'un sous-réseau adjacent au sous-réseau correspondant au bloc d'étiquette (140'₁, ..., 140'ₙ) et purge des données stockées dans ce bloc d'étiquette, et détecte une opération de régénération d'un sous-réseau correspondant au bloc d'étiquette et purge des données stockées dans ce bloc d'étiquette lorsque l'opération de régénération est achevée.

9. Mémoire vive dynamique selon la revendication 1, comprenant
un premier circuit de décodage (200) pour prédécoder une adresse (ADD) et pour émettre une adresse intermédiaire (a₀, ..., aₘ₋₁);
un premier bus d'adresse intermédiaire pour transmettre l'adresse intermédiaire; et
la mémoire d'étiquette étant constituée par une pluralité de blocs (210₁, ..., 210ₙ) et connectée au premier bus d'adresse intermédiaire (a₀, ..., aₘ₋₁);
chaque bloc (210₁, ..., 210ₙ) de la mémoire d'étiquette comprenant en outre :
(i) un circuit d'adresse d'étiquette (211₁, ..., 211ₙ) pour charger et stocker l'adresse intermédiaire et pour fournir l'adresse intermédiaire à un second circuit de décodage (220);
(ii) un circuit de comparaison d'adresse (213₁, ..., 213ₙ) pour comparer une adresse sur le bus d'adresse intermédiaire (a₀, ..., aₘ₋₁) avec une adresse stockée dans le circuit de conservation d'adresse d'étiquette (211₁, ..., 211ₙ); et
(iii) un circuit de purge (212₁, ..., 212ₙ) pour désactiver tous les bits conservés par le circuit de conservation d'adresse d'étiquette (211₁, ..., 211ₙ).

10. Mémoire vive dynamique selon la revendication 9, dans laquelle la mémoire vive est appliquée à un système d'amplificateur de lecture partagé qui partage une antémémoire à amplificateur de lecture ayant une pluralité de circuits de commande de sous-réseau (150₁, ..., 150ₙ) disposés dans chacun des blocs d'étiquette (140'₁, ..., 140'ₙ), pour commander l'amplificateur de lecture de colonne (120₁, ..., 120ₙ) de façon à le faire fonctionner comme une antémémoire; et un circuit de médiation d'amplificateur de lecture (111) pour valider une sortie et invalider une autre sortie relatives à des sorties partielles d'une paire des circuits de commande de sous-réseau (150₁, ..., 150ₙ) disposés de façon mutuellement adjacente l'un par rapport à l'autre.

11. Mémoire vive dynamique selon la revendication 1, dans laquelle
la pluralité de blocs d'étiquette (341) est destinée à conserver sous la forme d'un ensemble d'adresses d'étiquette, une adresse X pour sélectionner une cellule de mémoire du sous-réseau (310₁, 320₁, ..., 310ₙ, 320ₙ); et
un décodeur X (331) est incorporé dans chacun des sous-réseaux (310₁, 320₁, ..., 310ₙ, 320ₙ) pour décoder l'adresse X et sélectionner le conducteur de mot (WL); chacun des blocs d'étiquette (341) correspondants étant placé en position adjacente au décodeur X (331) incorporé dans chaque sous-réseau (310₁, 320₁, ..., 310ₙ, 320ₙ).

12. Mémoire vive dynamique selon la revendication 11, dans laquelle une pluralité des sous-réseaux (310₁, 320₁, ..., 310ₙ, 320ₙ) est placée sur les deux côtés extérieurs d'une région dans laquelle se trouvent la mémoire d'étiquette (340) constituée par une pluralité des blocs d'étiquette (341) , et le groupe de décodeurs X (330) constitué par une pluralité des décodeurs X (331).

13. Mémoire vive dynamique selon la revendication 11, dans laquelle une pluralité des sous-réseaux (320₁, ..., 320ₙ) est placée sur un côté extérieur d'une région dans laquelle se trouvent la mémoire d'étiquette (340) constituée par une pluralité des blocs d'étiquette (341), et le groupe de décodeurs X (330) constitué par une pluralité des décodeurs X (331).

14. Mémoire vive dynamique selon la revendication 11, dans laquelle des conducteurs de bit (BL) de chacun des sous-réseaux (310₁, 320₁, ..., 310ₙ, 320ₙ) sont disposés de manière à être placés dans une direction longitudinale d'une puce de semiconducteur (300).
